# EUROPEAN PATENT SPECIFICATION

(11) **EP 2 773 175 B1**
(45) Date of publication and mention of the grant of the patent: **30.05.2018**
(21) Application number: 12843331.5
(22) Date of filing: 10.10.2012
(51) Int. Cl.: H05K 13/02

(54) **TAPE FEEDER**
BANDZUFÜHRUNG
DISPOSITIF D'ALIMENTATION EN RUBAN

(30) Priority: 28.10.2011 JP 2011237232
(43) Date of publication of application: 03.09.2014
(73) Proprietor: Fuji Machine Mfg. Co., Ltd., Chiryu-shi Aichi 472-8686 (JP)
(72) Inventor: TAKADA, Yukinori, Chiryu-shi Aichi 472-8686 (JP)
(74) Representative: Grünecker Patent- und Rechtsanwälte PartG mbB
(86) International application number: PCT/JP2012/076184
(87) International publication number: WO 2013/061775

(56) References cited:
- EP-A1- 1 307 083
- JP-A- 2005 142 574
- JP-A- 2005 503 677
- JP-A- 2006 093 739
- US-A- 5 414 585
- US-A1- 2006 027 693
- US-B1- 6 886 766

## Description

### TECHNICAL FIELD

The present invention relates to a tape feeder with an improved guide mechanism for guiding component supply tape in which multiple electronic components are arranged at a specific pitch to a component pickup position.

### BACKGROUND TECHNOLOGY

Conventional tape feeders, as disclosed in Prior Art 1 (Japanese Unexamined Patent Application Publication Number 2010-109109), index electronic component supply tape to a component pickup position by rotating a sprocket, the teeth of which are engaged with sprocket holes which are arranged at a specific pitch along the edge of component supply tape, such that components in the component supply tape can be picked up by a suction nozzle of an electronic component mounter at a component pickup position.

On this tape feeder, the guide mechanism for guiding the component supply tape to a component pickup position, as given in Prior Art 2 (Japanese Unexamined Patent Application Publication Number 2009-71207), is formed with 2 guides which extend along both edges of the component supply tape set in the tape feeder, and the component supply tape passes between the 2 guides.

### PRIOR ART REFERENCES

### PRIOR ART

Prior Art 1: Japanese Unexamined Patent Application Publication Number 2010-109109
[Prior Art 2] Japanese Unexamined Patent Application Publication Number 2009-71207

### BRIEF SUMMARY OF THE INVENTION

### PROBLEM SOLVED BY INVENTION

With the above current guide mechanism, because there are 2 guides along both edges of the component supply tape set in the tape feeder, the minimum required width dimensions of the tape feeder are "Thickness dimension of the 2 guides" + "Clearance between the guides and component supply tape" + "Width dimension of the component supply tape", and it is impossible to make the width dimension of the tape feeder any thinner than this.

EP 1 307 083 A1 discloses a tape feeder according to the preamble of claim 1.

With respect to this, for the problem to be solved by this invention, what is proposed is a tape feeder for which the width dimension can be made thinner.

### MEANS OF SOLVING THE PROBLEM

In order to solve the above problem, the present invention provides a tape feeder according to claim 1 which indexes component supply tape in which multiple electronic components are arranged at a specific pitch to a component pickup position, wherein the tape feeder is equipped with multiple guide material for guiding the component supply tape to the component pickup position, and the multiple guide material supports each component supply tape on only one side in a widthwise direction and are arranged in a zig-zag pattern alternating on one side of the component supply tape widthwise and the other side. With this configuration, because the guide material supporting component supply tape on only one in a widthwise direction is configured such it is arranged in a zig-zag pattern alternating on one side of the component supply tape widthwise and the other side, compared items with the conventional configuration in which there are 2 guides along both sides of the component tape, the width dimension of the tape feeder can be made thinner.

The tape feeder according to claim 1 has a configuration such that the component supply tape is supported in a state that is slightly contorted in a widthwise direction or tilted diagonally by having the multiple guide materials arranged slightly offset towards the inside in a widthwise direction of each component supply tape. If this is done, the width dimension of the guide mechanism for guiding the component supply tape to the component pickup position can be made thinner up to the point of having just about the same dimension as the width dimension of the component supply tape.

### BRIEF DESCRIPTION OF THE DRAWINGS

[FIG. 1]

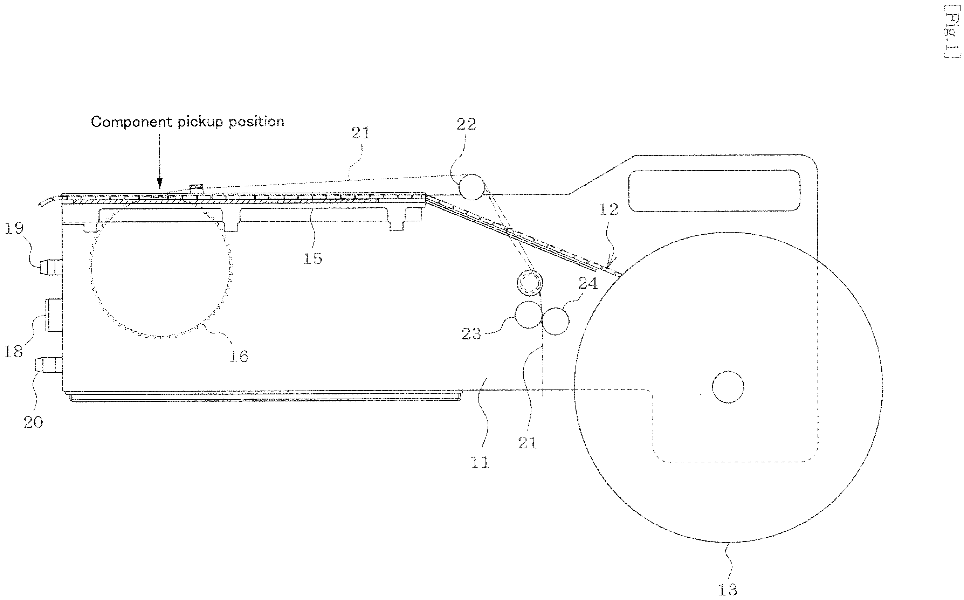

   FIG. 1 is a perspective view showing the entire tape feeder from an embodiment of the present invention.
[FIG. 2]

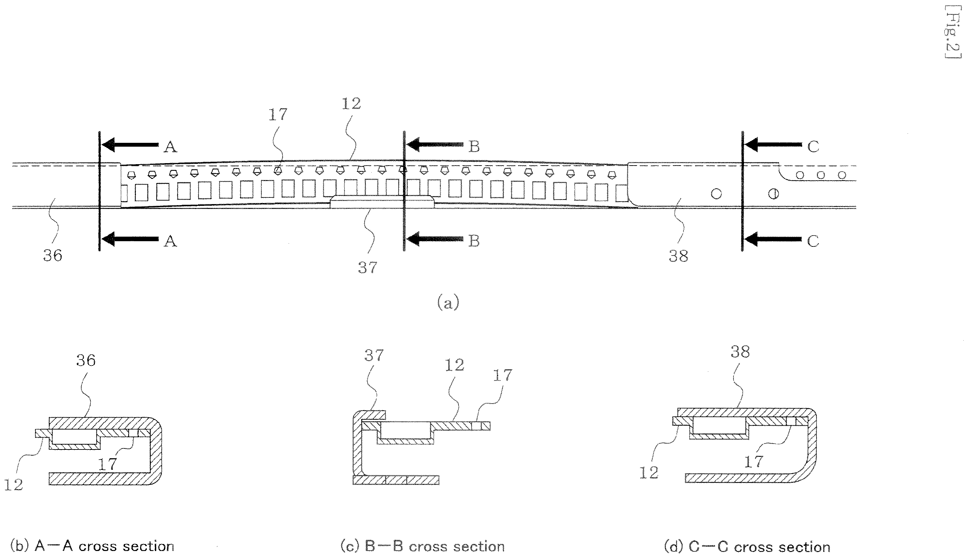

   FIG. 2 (a) is a top view of the end section of the tape path; (b) is a cross-section view showing (a) along the line A-A; (c) is a cross-section view showing (a) along the line B-B; and (d) is a cross-section view showing (a) along the line C-C.

### MODE FOR CARRYING OUT THE INVENTION

The following uses figures to describe a specific embodiment of the present invention.

First, the configuration of the tape feeder is described based on FIG. 1.

Tape reel 13 with component supply tape 12 wound on it can be removably set on the end section (the right side in FIG. 1) of tape feeder 11. Tape path material 15 which forms a tape path for guiding component supply tape 12 pulled out from tape reel 13 to a component pickup position is attached to the top surface of tape feeder 11.

Sprocket 16 for pitch indexing component supply tape 12 set in tape path material 15 to a component pickup position and a motor (not shown) for rotating this are attached to the rear side (the left side in FIG. 1) of tape feeder 11, and the position directly above the rotation center of sprocket 16 is the component pickup position.

Sprocket holes 17 (refer to FIG. 2) are formed at a specific pitch along one of the edges of component supply tape 12, and by rotating sprocket 16 while the teeth of sprocket 16 become consecutively engaged with these sprocket holes 17, component supply tape 12 is made to be pitch indexed.

The rear end of tape feeder 11 (the left side in FIG. 1) is equipped with communication connector 18 for connecting to the connector at the electronic component mounter side (not shown) and positioning pins 19 and 20 for deciding the attachment position with respect to the electronic component mounter. Also, tape feeder 11 is equipped with cover tape indexing rollers 22 to 24 for indexing cover tape 21 (top tape) peeled back from component supply tape 12 which is pulled out from tape reel 13.

As shown in FIG. 2, on the upper surface of tape path material 15, multiple (for example 3 or more than 3) C-shaped guides 36 to 38 which support component supply tape 12 from one side only are arranged so that one supports component supply tape 12 from one side while the other supports it from the other side in an alternating zig-zag pattern; this slightly contorts component supply tape 12 widthwise (or tilts it diagonally) while supporting it, with each guide 36 to 38 arranged slightly offset within the width of component supply tape 12, meaning that the component supply tape 12 can be supported within a narrower width.

With the embodiment described above, because the guides 36 to 38 supporting component supply tape 12 on only one in a widthwise direction are configured such that they are arranged in a zig-zag pattern alternating on one side of component supply tape 12 widthwise and the other side, compared items with the conventional configuration in which there are 2 guides along both sides of component tape 12, the width dimension of the tape feeder can be made thinner.

Furthermore, in this embodiment, by arranging multiple guides 36 to 38 slightly offset towards the inside in a widthwise direction of each component supply tape 12, because component supply tape is supported in a state that is slightly contorted in a widthwise direction or tilted diagonally, the width dimension of the guide mechanism for guiding component supply tape 12 to the component pickup position can be made thinner up to the point of having just about the same dimension as the width dimension of component supply tape 12.

Furthermore, for the present invention, it goes without saying that it is possible to have an embodiment with various changes that does not extend beyond the scope of the invention such as embodiments using a wide range of tape feeders with various configurations.

### SYMBOL DESCRIPTIONS

11. Tape feeder; 12. Component supply tape; 13. Tape reel; 15. Tape path material; 16. Sprocket; 17. Sprocket hole; 21. Cover tape; 22 to 24. Cover tape indexing roller; 36 to 38. Guide

## Claims

1. A tape feeder (11) which indexes component supply tape (12) in which multiple electronic components are arranged at a specific pitch to a component pickup position, wherein the tape feeder (11) is equipped with multiple guide materials (36, 37, 38) for guiding said component supply tape (12) to said component pickup position, wherein said multiple guide materials (36, 37, 38) each support said component supply tape (12) on only one side in a widthwise direction, **characterized in that** said multiple guide materials (36, 37, 38) are each arranged in a zig-zag pattern alternating from one side of said component supply tape widthwise to the other side of the component supply tape (12) widthwise, and are each arranged slightly offset towards the inside of the component supply tape (12) in a widthwise direction, wherein the tape feeder (11) has a configuration such that said component supply tape (12) is supported in a state that is slightly contorted in a widthwise direction or tilted diagonally.

2. The tape feeder (11) according to claim 1, wherein the multiple guide materials (36, 37, 38) have a C-shaped cross-section.

## Patentansprüche

1. Band-Zuführvorrichtung (11), die Bauteil-Zuführband (12), in dem mehrere elektronische Bauteile in einem vorgegebenen Abstand angeordnet sind, schrittweise zu einer Bauteil-Aufnahmeposition transportiert, wobei die Band-Zuführvorrichtung (11) mit mehreren Führungs-Materialien (36, 37, 38) versehen ist, mit denen das Bauteil-Zuführband (12) zu der Bauteil-Aufnahmeposition geführt wird, und die mehreren Führungs-Materialien (36, 37, 38) das Bauteil-Zuführband (12) jeweils nur an einer Seite in einer Breitenrichtung tragen, **dadurch gekennzeichnet, dass** die mehreren Führungs-Materialien (36, 37, 38) jeweils in einer Zickzack-Struktur angeordnet sind, die von einer Seite des Bauteil-Zuführbandes in Breitenrichtung zu der anderen Seite des Bauteil-Zuführbandes (12) in Breitenrichtung wechselt, und sie jeweils geringfügig versetzt zur Innenseite des Bauteil-Zuführbandes (12) in einer Breitenrichtung angeordnet sind, wobei die Band-Zuführvorrichtung (11) so aufgebaut ist, dass das Bauteil-Zuführband (12) in einem Zustand getragen wird, in dem es in einer Breitenrichtung geringfügig verdreht oder diagonal geneigt ist.

2. Band-Zuführvorrichtung (11) nach Anspruch 1, wobei die mehreren Führungs-Materialien (36, 37, 38) einen C-förmigen Querschnitt haben.

## Revendications

1. Dispositif d'alimentation en bande (11) qui indexe une bande de délivrance de composants (12) dans laquelle de multiples composants électroniques sont agencés avec un pas spécifique sur une position de prélèvement de composant, le dispositif d'alimentation en bande (11) étant muni de multiples matériaux de guidage (36, 37, 38) permettant de guider ladite bande de délivrance de composants (12) vers ladite position de prélèvement de composant, lesdits multiples matériaux de guidage (36, 37, 38) supportent chacun ladite bande de délivrance de composants (12) sur un seul côté dans la direction de la largeur, **caractérisé en ce que** lesdits multiples matériaux de guidage (36, 37, 38) sont chacun disposé selon un motif de lignes brisées alternant dans la direction de la largeur depuis un côté de ladite bande de délivrance de composants jusqu'à l'autre côté de la bande de délivrance de composants (12) et sont chacun agencé pour être légèrement décalé vers l'intérieur de la bande de délivrance de composants (12) dans la direction de la largeur, le dispositif d'alimentation en bande (11) présentant une configuration telle que ladite bande de délivrance de composants (12) est supportée tout en étant légèrement déformée dans la direction de la largeur ou bien inclinée diagonalement.

2. Dispositif d'alimentation en bande (11) selon la revendication 1, dans lequel les multiples matériaux de guidage (36, 37, 38) présentent une section transversale en forme de C.
